# EUROPÄISCHE PATENTSCHRIFT

(11) **EP 1 212 796 B1**
(45) Veröffentlichungstag und Bekanntmachung des Hinweises auf die Patenterteilung: **14.03.2007**
(21) Anmeldenummer: 00967584.4
(22) Anmeldetag: 15.09.2000
(51) Int. Cl.: H01L 27/02

(54) **ESD-SCHUTZANORDNUNG FÜR SIGNALEINGÄNGE UND -AUSGÄNGE MIT ÜBERSPANNUNGSTOLERANZ**
ESD PROTECTIVE ARRANGEMENT FOR SIGNAL INPUTS AND OUTPUTS, SAID ARRANGEMENT HAVING AN OVERVOLTAGE TOLERANCE
DISPOSITIF DE PROTECTION CONTRE LES DECHARGES ELECTROSTATIQUES POUR ENTREES ET SORTIES DE SIGNAUX AVEC TOLERANCE VIS-A-VIS DES SURTENSIONS

(30) Priorität: 16.09.1999 DE 19944488
(43) Veröffentlichungstag der Anmeldung: 12.06.2002
(73) Patentinhaber: Infineon Technologies AG, 81669 München (DE)
(72) Erfinder: GOSSNER, Harald, 85521 Riemerling (DE)
(74) Vertreter: Kottmann, Heinz Dieter
(86) Internationale Anmeldenummer: PCT/DE2000/003251
(87) Internationale Veröffentlichungsnummer: WO 2001/020677

(56) Entgegenhaltungen:
- EP-A- 0 893 868
- DE-A- 19 735 424
- US-A- 5 698 886
- US-A- 5 869 872
- US-A- 5 930 094

## Beschreibung

Die vorliegende Erfindung betrifft eine ESD-Schutzanordnung (ESD = Electrostatic Discharge) für Signaleingänge und -ausgänge mit Überspannungstoleranz bei CMOS-Schaltungen, mit einem als ESD-Schutzelement ausgebildeten NMOS-Transistor, der mit einem I/O-(Eingabe/Ausgabe-)Pad (bzw. Kontaktkissen) der CMOS-Schaltung verbunden ist.

In moderner CMOS-Technologie werden Bauelemente für die dort niedrigen Betriebsspannungen von 1,8 V und darunter ausgelegt, um bei derart optimierten Bauelementen deren Verlustleistung klein zu halten, für diese eine höhere Packungsdichte zu erzielen und schließlich auch eine größere Schnelligkeit von Einzeltransistoren durch geringere geometrische Abmessungen zu erreichen. Eine derartige Optimierung der Bauelemente in CMOS-Technologie ist ohne größeren Aufwand zu erreichen und bietet, wie angedeutet wurde, erhebliche Vorteile.

Es läßt sich allerdings nicht vermeiden, daß viele der in dieser Technologie verwirklichten CMOS-Schaltungen auch in elektrischen Umgebungen eingesetzt werden müssen, in denen an diesen Schaltungen Signale mit höheren Spannungen von beispielsweise 3,3 V oder 5 V ankommen. Aus diesem Grund muß bei solchen CMOS-Schaltungen im I/O-Bereich eine höhere Spannungsfestigkeit als in deren Kern- bzw. Core-Bereich garantiert werden.

Da das Gateoxid von CMOS-Transistoren durch höhere Spannungen als Nennspannungen beschädigt wird, wirkt in aller Regel zumeist die Spannung limitierend, die maximal über dem Gateoxid der eingesetzten CMOS-Transistoren unter Berücksichtigung der hierfür spezifizierten Lebensdauer auftreten darf.

Um eine höhere Spannungsfestigkeit im I/O-Bereich zu erzielen, kann zunächst an zwei grundsätzlich verschiedene Möglichkeiten gedacht werden. Zum einen können zusätzliche I/O-Transistoren mit größerer Dicke des Gateoxids eingesetzt werden. Dies führt aber zu einer erheblichen Verteuerung des Herstellungsprozesses, so daß diese Möglichkeit als weniger wirtschaftlich anzusehen ist. Zum anderen können besondere schaltungstechnische Maßnahmen für beispielsweise Inverter bzw. Ausgangstreiber der CMOS-Schaltung eingesetzt werden, wie beispielsweise ein "Stacking" bzw. Stapeln von NMOS-Transistoren und ein Ansteuern der Wanne eines PMOS-Transistors, was auch als "floating well" bezeichnet wird. In der Praxis hat sich dieses Konzept von "stacked" NMOS und von "floating well" PMOS als ESD-Schutz kaum durchgesetzt, da es zu einer Verringerung der ESD-Performance, also speziell zu einer niedrigeren ESD-Festigkeit und einer höheren Klemmspannung, führt.

In der Fachliteratur bisher beschriebene Lösungsansätze für das obige Problem einer höheren Spannungsfestigkeit im I/O-Bereich von CMOS-Schaltungen verwenden eine Serienschaltung von NMOS-Transistoren (W. Anderson, D. Krakauer: EOS/ESD Symp. Proc., 1998, S. 54-62), welche als ESD-Schutzelemente ausgebildet sind. Eine solche Serienschaltung verringert aber oftmals die ESD-Performance hinsichtlich der ESD-Festigkeit des entsprechenden ESD-Schutzelernentes und der Spannungsbegrenzung im Hochstrombereich, so daß eine reduzierte Schutzwirkung vorliegt.

Dickoxidtransistoren, die in moderner CMOS-Technologie auf "shallow trench isolation" (flache Graben-Isolation) beruhen, weisen eine schlechte ESD-Festigkeit auf und kommen in anderen Technologien als in LOCOS als Schutzelemente kaum in Betracht. Alternativ können auch substratgetriggerte laterale NPN-Transistoren eingesetzt werden. Diese werden in der Fachliteratur aber lediglich im Zusammenhang mit Epitaxie-Prozessen diskutiert (vgl. J. Smith: EOS/ESD Symp. Proc., 1998, S.63-71).

Das den Oberbegriff der Ansprüche 1 und 2 zeigende Dokument DE 197 35 424 A1 beschreibt einen MOS-Transistor mit an Masse liegendem Gate als Schutz gegen elektrostatische Entladung mit einer verringerten Druchbruchsspannung, in dem die Dotierungsmittelkonzentration des Substrats an der Drain-Substrat-Sperrschicht erhöht wird. Die Fertigung des Transistors kann in einen Standard-CMOS-Herstellungsprozess eingegliedert werden, ohne dass zusätzliche Masken benötigt werden, indem man das Substrat gleichzeitig mit den leicht dotierten Drainregionen der CMOS-Komponenten implantiert.

Es ist daher Aufgabe der vorliegenden Erfindung, eine ESD-Schutzanordnung für Signaleingänge und -ausgänge mit Überspannungstoleranz anzugeben, die es auf einfache Weise und mit hoher ESD-Performance erlaubt, den I/O-Bereich von CMOS-Schaltungen vor Überspannungen zu schützen.

Diese Aufgabe wird bei einer ESD-Schutzanordnung der eingangs genannten Art erfindungsgemäß so gelöst, wie es in den Patentansprüchen 1 und 2 definiert ist.

Bei der erfindungsgemäßen ESD-Schutzanordnung wird also ein NMOS-Transistor mit hoher Schwellenspannung, die etwa 2 V betragen kann, als zentrales ESD-Schutzelement verwendet. Gate dieses NMOS-Transistors ist mit einer erhöhten Spannung, von beispielsweise 1 V beaufschlagt. Dabei tritt noch kein relevanter Leckstrom auf. Durch diese Vorspannung an Gate verringert sich aber entsprechend der Spannungsabfall über das Gateoxid zur Drainseite des NMOS-Transistors.

Die Erhöhung der Schwellenspannung des NMOS-Transistors wird entweder durch eine geeignete Dotierung seiner schwach dotierten bzw. LDD-Gebiete erreicht, indem die n⁺-leitende Sourcezone und die n⁺-leitende Drainzone in ihrem jeweiligen, an den Kanal angrenzenden Bereich unterhalb der Gateelektrode mit einer pldd-Implantation anstelle einer nldd-Implantation versehen werden (pldd = schwach p-dotiert; nldd = schwach n-dotiert).

Die andere Möglichkeit zur Erhöhung der Schwellenspannung besteht darin, im Kanalbereich zwischen Sourcezone und Drainzone eine zusätzliche Kanaldotierung beispielsweise durch Implantation, einzubringen, so daß hier bei n⁺-dotierten Source- und Drainzonen eine erhöhte p-Dotierungskonzentration besteht.

Beide oben genannten Möglichkeiten, nämlich eine geeignete Dotierung der LDD-Gebiete und eine entsprechende Kanaldotierung, können relativ einfach realisiert werden. Insbesondere ist das Ersetzen von nldd durch pldd in den LDD-Gebieten ohne zusätzlichen Prozeßschritt zu verwirklichen. Dies gilt unabhängig davon, ob für die Realisierung der ESD-Schutzanordnung eine Epitaxie-Technologie oder nicht verwendet wird.

Schließlich bereitet bei der erfindungsgemäßen ESD-Schutzanordnung auch die Beschaltung von Gate des NMOS-Transistors keine Probleme: die Vorspannung für Gate von beispielsweise 1 V kann aus einer in der CMOS-Schaltung generierten Bandgap-Spannung abgeleitet werden. Die andere Möglichkeit besteht darin, zwischen dem I/O-Pad und der niedrigen Versorgungsspannung einen hochohmigen Spannungsteiler beispielsweise unter Verwendung eines PNP-Transistors einzubauen.

Nachfolgend wird die Erfindung anhand der Zeichnungen näher erläutert. Es zeigen:
- Fig. 1: eine schematische Schnittdarstellung eines ESD-Schutztransistors mit hoher Schwellen spannung durch Verwendung einer pldd-Implantation,
- Fig. 2: einen schematischen Schnitt eines ESD-Schutztransistors mit hoher Schwellenspannung durch Verwendung einer zusätzlichen Kanal-Implantation,
- Fig. 3: eine nicht beanspruchte ESD-Schutzanordnung gegen niedrige Versorgungsspannung Vₛₛ für ein überspannungstolerantes Signal- bzw. I/O-Pad auf der Basis eines Hochspannungs- bzw. VHV-NMOS-Transistors mit angesteuertem Gate,
- Fig. 4 und 5: zwei Beispiele für die Ansteuerung des Gates eines als ESD-Schutzelementes dienenden VHV-NMOS-Transistors,
- Fig. 6: ein Schaltungsbeispiel für einen hochohmigen Spannungsteiler am I/O-Pad zur Ansteuerung des Gates eines VHV-NMOS-Transistors,
- Fig. 7: ein weiteres Schaltungsbeispiel für einen hochohmigen Spannungsteiler am I/O-Pad zur Ansteuerung des Gates eines VHV-NMOS-Transistors,
- Fig. 8: eine schematische Schnittdarstellung für eine kompakte Ausführung des hochohmigen Spannungsteilers von Fig. 7 und
- Fig. 9: einen Schnitt eines Thyristors auf der Basis eines VHV-NMOS-Transistors.

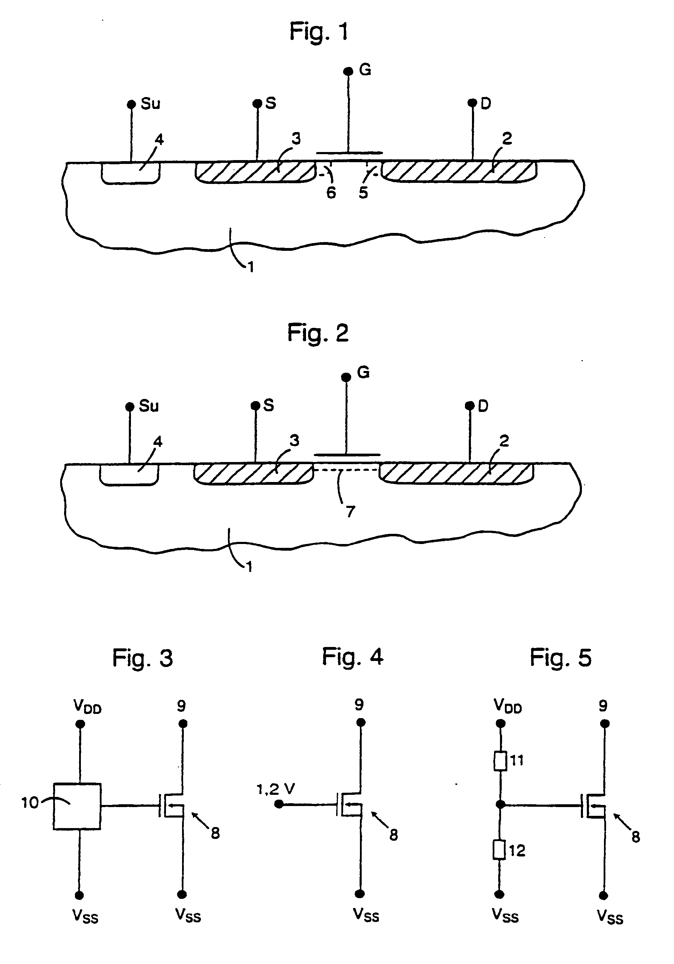

Fig. 1 zeigt in einer p-leitenden Siliziumwanne 1 eine n⁺-leitende Drainzone 2 mit einer Drainelektrode D, eine n⁺-leitende Sourcezone 3 mit einer Sourceelektrode S und eine p⁺-leitende Kontakt- bzw. Anschlußzone 4 mit einem Substratkontakt Su. Zur Erhöhung seiner Schwellenspannung weist der so gebildete ESD-Schutztransistor pldd-Implantationsgebiete 5, 6 auf. Diese pldd-Implantationsgebiete 5, 6 sind anstelle von sonst vorhandenen nldd-Implantationsgebieten vorgesehen und bewirken durch die Verlängerung des Kanales zwischen Sourcezone 3 und Drainzone 2 eine Erhöhung der Schwellenspannung.

Diese Erhöhung der Schwellenspannung kann auch erreicht werden, wenn im Kanalbereich zwischen Sourcezone 3 und Drainzone 2 eine zusätzliche Kanalimplantation 7 angebracht wird, wie dies schematisch in Fig. 2 gezeigt ist.

Im folgenden wird anhand der Fig. 3 bis 7 beschrieben, wie der in der Fig. 1 oder 2 gezeigte VHV-NMOS-Transistor mit erhöhter Schwellenspannung bei der erfindungsgemäßen ESD-Schutzanordnung beschaltet wird.

Fig. 3 zeigt ein nicht beanspruchtes Beispiel, in welchem ein solcher VHV-NMOS-Transistor 8 zwischen einem I/O- bzw. Signalpad 9 und niedriger Versorgungsspannung Vₛₛ liegt. Gate dieses VHV-NMOS-Transistors 8 ist mit einer Spannungsquelle 10 verbunden, welche von der CMOS-Schaltung zwischen niedrigem Versorgungspotential Vₛₛ und hohem Versorgungspotential V_{dd} gebildet ist.

In Fig. 4 ist ein Beispiel gezeigt, bei welchem eine Bandgap-Spannung von 1,2 V als Vorspannung für den VHV-NMOS-Transistor herangezogen wird. Diese Bandgap-Spannung von 1,2 V liegt in CMOS-Schaltungen beispielsweise an "phase locked loops" (PLL; phasenverriegelte Schleifen) vor.

Fig. 5 zeigt ein weiteres Beispiel für die Generierung der Vorspannung für den VHV-NMOS-Transistor 8: für die Erzeugung der Vorspannung wird in diesem Beispiel ein Spannungsteiler aus zwei Widerständen 11, 12 verwendet, die in Reihe zwischen der niedrigen Versorgungsspannung Vₛₛ und der hohen Versorgungsspannung V_{dd} liegen.

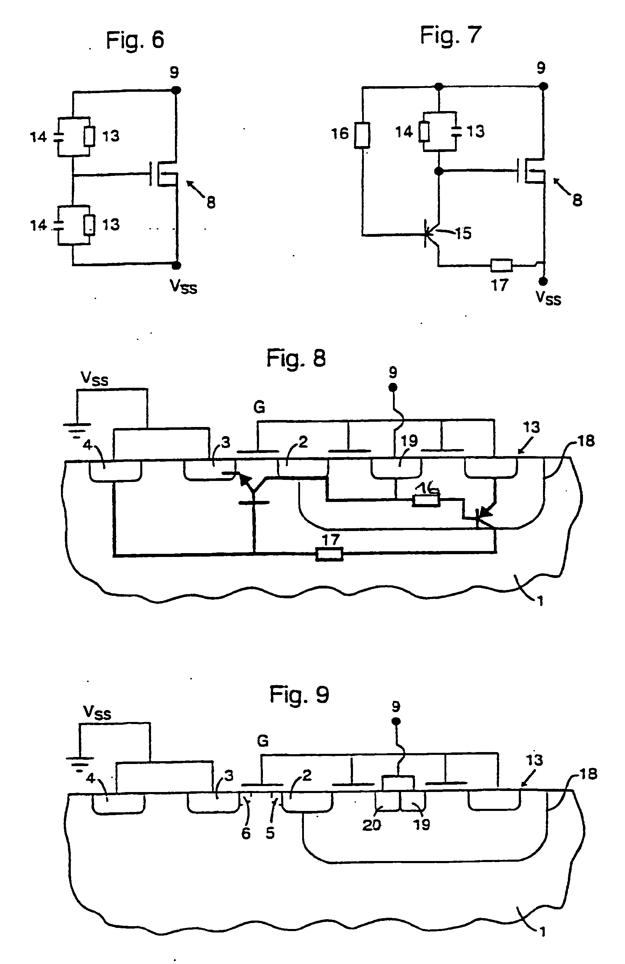

Während in den Beispielen der Fig. 3 bis 5 die Vorspannung für den VHV-NMOS-Transistor 8 in der CMOS-Schaltung generiert wird, geschieht dies bei den Beispielen der Fig. 6 und 7 durch hochohmige Spannungsteiler, die direkt am I/O-Pad 9 liegen und mit ihrem anderen Ende mit der niedrigen Versorgungsspannung Vₛₛ beaufschlagt sind. In Fig. 6 besteht der Spannungsteiler aus Parallelschaltungen eines Widerstandes 13 und eines Kondensators 14, während bei dem Beispiel von Fig. 7 eine Parallelschaltung des Beispiels von Fig. 6 durch einen PNP-Transistor 15 ersetzt ist, dessen Basis über einen Widerstand 16 mit dem I/O-Pad 9 verbunden ist. Der Kollektor dieses Transistors 15 ist über einen Widerstand 17 mit der niedrigen Versorgungsspannung Vₛₛ verbunden.

Fig. 8 zeigt schematisch, wie beispielsweise die Schaltungsanordnung von Fig. 7 mit einer kompakten Ausführung realisiert werden kann. Zusätzlich zu den bereits erläuterten Teilen sind in Fig. 8 noch eine n-leitende Wanne 18 und ein n⁺-leitendes Kontakt- bzw. Anschlußgebiet 19 für diese n-leitende Wanne 18 gezeigt.

Schließlich zeigt Fig. 9 ein Beispiel, wie durch Anbringung einer weiteren p⁺-leitenden Zone 20 in der n-leitenden Wanne 18 eine Thyristorstruktur erzeugt werden kann.

## Patentansprüche

1. ESD-Schutzanordnung für Signaleingänge und -ausgänge mit Oberspannungstoleranz bei CMOS-Schaltungen, mit einem als ESD-Schutzelement ausgebildeten NMOS-Transistor (8), der mit einem I/O-Pad (9) der CMOS-Schaltung verbunden ist, wobei der NMOS-Transistor (8) zwischen dem I/O-Pad (9) und niedriger Versorgungsspannung Vₛₛ liegt, an seinem Gate (G) mit einer Vorspannung beaufschlagbar ist und eine hohe Schwellenspannung aufweist, die durch entsprechende Kanaldotierung zwischen einer Sourcezone (3) und einer Drainzone (2) zur Erzielung einer erhöhten p-Dotierungskonzentration oder durch entsprechende Dotierung von pLDD-Gebieten (5, 6) erzielt ist,
**dadurch gekennzeichnet,**
**dass**
das I/O-Pad (9) mit einem hochohmigen Spannungsteiler (13, 14, 15, 16, 17) verbunden ist, über den die Vorspannung am Gate anliegt.

2. ESD-Schutzanordnung für Signaleingänge und -ausgänge mit Oberspannungstoleranz bei CMOS-Schaltungen, mit einem als ESD-Schutzelement ausgebildeten NMOS-Transistor (8), der mit einem I/O-Pad (9) der CMOS-Schaltung verbunden ist, wobei der NMOS-Transistor (8) zwischen dem I/O-Pad (9) und niedriger Versorgungsspannung Vₛₛ liegt, an seinem Gate (G) mit einer Vorspannung beaufschlagbar ist und eine hohe Schwellenspannung aufweist, die durch entsprechende Kanaldotierung zwischen einer Sourcezone (3) und einer Drainzone (2) zur Erzielung einer erhöhten p-Dotierungskonzentration oder durch entsprechende Dotierung von pLDD-Gebieten (5, 6) erzielt ist,
**dadurch gekennzeichnet,**
- **dass** die Vorspannung die Bandgap-Spannung ist.

3. ESD-Schutzanordnung nach einem der Ansprüche 1 bis 2,
**dadurch gekennzeichnet,**
**dass** die Vorspannung etwa 1 V beträgt.

## Claims

1. ESD protection arrangement for signal inputs and outputs with overvoltage tolerance in CMOS circuits, having an NMOS transistor (8) which is designed as an ESD protection element and is connected to an I/O pad (9) of the CMOS circuit, the NMOS transistor (8) being connected between the I/O-Pad (9) and low supply voltage Vₛₛ, a bias voltage being able to be applied to the gate (G) of said NMOS transistor and said NMOS transistor having a high threshold voltage which is obtained by corresponding channel doping between a source zone (3) and a drain zone (2) for obtaining an increased p-type doping concentration or by corresponding doping of pLDD regions (5, 6),
**characterized in that**
the I/O pad (9) is connected to a high-impedance voltage divider (13, 14, 15, 16, 17), via which the bias voltage is applied to the gate.

2. ESD protection arrangement for signal inputs and outputs with overvoltage tolerance in CMOS circuits, having an NMOS transistor (8) which is designed as an ESD protection element and is connected to an I/O pad (9) of the CMOS circuit, the NMOS transistor (8) being connected between the I/O-Pad (9) and low supply voltage Vₛₛ, a bias voltage being able to be applied to the gate (G) of said NMOS transistor and said NMOS transistor having a high threshold voltage which is obtained by corresponding channel doping between a source zone (3) and a drain zone (2) for obtaining an increased p-type doping concentration or by corresponding doping of pLDD regions (5, 6),
**characterized in that**
the bias voltage is the bandgap voltage.

3. ESD protection arrangement according to one of Claims 1 to 2,
**characterized**
**in that** the bias voltage is about 1 V.

## Revendications

1. Dispositif de protection ESD des entrées et des sorties de signaux ayant une tolérance vis-à-vis de la surtension dans des circuits CMOS, comprenant un transistor NMOS (8) constitué en élément de protection ESD et relié à une plage I/O (9) du circuit CMOS, le transistor NMOS (8) se trouvant entre la plage I/O (9) et la tension Vₛₛ basse d'alimentation, pouvant être alimenté sur sa grille (G) par une tension de polarisation et ayant une haute tension de seuil qui est obtenue par un dopage adéquat du canal entre une zone (3) de source et une zone (2) de drain pour obtenir une concentration plus grande de dopage du type p ou par un dopage correspondant de zones pLDD (5, 6),
**caractérisé**
**en ce que** la plage (9) I/O est reliée à un diviseur (13, 14, 15, 16, 17) de tension à grande valeur ohmique, par lequel la tension de polarisation est appliquée à la grille.

2. Dispositif de protection ESD des entrées et des sorties de signaux ayant une tolérance vis-à-vis de la surtension dans des circuits CMOS, comprenant un transistor NMOS (8) constitué en élément de protection ESD et relié à une plage I/O (9) du circuit CMOS, le transistor NMOS (8) se trouvant entre la plage I/O (9) et la tension Vₛₛ basse d'alimentation pouvant être alimenté sur sa grille (G) par une tension de polarisation et ayant une haute tension de seuil qui est obtenue par un dopage adéquat du canal entre une zone (3) de source et une zone (2) de drain pour obtenir une concentration plus grande de dopage du type p ou par un dopage correspondant de zones pLDD (5, 6),
**caractérisé**
**en ce que** la tension de polarisation est la tension de bandgap.

3. Dispositif de protection ESD suivant l'une des revendications 1 à 2,
**caractérisé**
**en ce que** la tension de polarisation est d'environ 1 V.
